Europäisches Patentamt

European Patent Office

Office européen des brevets

(19)

(11) **EP 1 183 718 B1**

(12) **EUROPÄISCHE PATENTSCHRIFT**

(45) Veröffentlichungstag und Bekanntmachung des
Hinweises auf die Patenterteilung:
**09.03.2005 Patentblatt 2005/10**

(51) Int Cl.⁷: **H01L 21/28**, H01L 21/8247,
H01L 29/788, H01L 27/115

(21) Anmeldenummer: **00945637.7**

(22) Anmeldetag: **09.06.2000**

(86) Internationale Anmeldenummer:
**PCT/DE2000/001898**

(87) Internationale Veröffentlichungsnummer:
**WO 2000/077838 (21.12.2000 Gazette 2000/51)**

(54) **Herstellungsverfahren einer NICHTFLÜCHTIGEN HALBLEITER-SPEICHERZELLE**

Method of manufacturing a NON-VOLATILE SEMICONDUCTOR MEMORY CELL

PROCEDE DE FABRICATION D'UNE CELLULE MEMOIRE A SEMI-CONDUCTEUR NON
VOLATILE

(84) Benannte Vertragsstaaten:
**DE FR GB IT**

(30) Priorität: **10.06.1999 DE 19926500**

(43) Veröffentlichungstag der Anmeldung:
**06.03.2002 Patentblatt 2002/10**

(73) Patentinhaber: **Infineon Technologies AG
81669 München (DE)**

(72) Erfinder:
• **LUDWIG, Christoph
D-01465 Langenbrück (DE)**

• **SCHREMS, Martin
D-01465 Langenbrück (DE)**

(74) Vertreter: **Kindermann, Peter, Dipl.-Ing.
Kindermann Patentanwälte
Postfach 1330
85627 Grasbrunn (DE)**

(56) Entgegenhaltungen:
**DE-A- 2 711 895       US-A- 4 734 887
US-A- 5 384 729       US-A- 5 897 354
US-A- 5 907 780       US-A- 5 998 264**

**Beschreibung**

Die vorliegende Erfindung bezieht sich auf eine nichtflüchtige Halbleiter-Speicherzelle und ein Verfahren zu deren Herstellung und insbesondere auf eine Halbleiter-Speicherzelle, wie sie in EPROM, EEPROM und FLASH-EPROM verwendet wird.

Nichtflüchtige Speicher, wie z. B. EPROM, EEPROM und FLASH-EPROM's sind allgemein bekannt. Üblicherweise bestehen derartige nichtflüchtige Speicher aus einer Vielzahl von Transistoren, die als Speicherzellen arbeiten. Jeder Speicher besteht aus einem Source- und Drain-Gebiet, welche an der Oberfläche eines Halbleitersubstrats ausgebildet sind. An der Oberfläche des Halbleitersubstrats befindet sich üblicherweise eine Isolierschicht, auf der ein sogenanntes Floating-Gate zum Speichern von Ladungen ausgebildet ist. Über dem Floating-Gate befindet sich ein sogenanntes Steuer-Gate, das durch eine weitere Isolierschicht vom Floating-Gate getrennt ist.

Zum Speichern einer logischen Information werden im Floating-Gate entweder eine geringe oder eine große Anzahl von Ladungen abgelegt, die das Schaltverhalten des darunterliegenden Kanalgebiets bzw. FETs beeinflussen. Da der Wert der im Floating-Gate gespeicherten Daten eine Funktion der darin gespeicherten Ladungsgröße darstellt, kann ein Ladungsverlust im Floating-Gate die in der Speicherzelle gespeicherte Information verändern. Für das Funktionieren einer nichtflüchtigen Speicherzelle ist es daher außerordentlich wichtig, daß die im Floating-Gate gespeicherten Ladungen lange gehalten werden.

Diese Eigenschaften zum Halten von Ladungen werden insbesondere durch die das Floating-Gate umgebenden Isolierschichten bestimmt. Zur Verhinderung eines Ladungsverlustes müssen die Isolierschichten eine hohe Durchbruchspannung aufweisen. Wenn beispielsweise während eines Programmiervorgangs an das Steuergate eine hohe Spannung angelegt wird, so muß die Isolierschicht eine ausreichend hohe Durchbruchspannung aufweisen, um einen Elektronenfluß vom Floating-Gate zum Steuer-Gate zu verhindern.

Andererseits muß nach dem Einbringen der Ladungen in das Floating-Gate die Isolierschicht einen Leckstrom aus dem Floating-Gate ausreichend verhindern. Derartige Leckströme werden üblicherweise durch sogenannte "pin holes" und andere Defekte in der isolierenden Schicht erzeugt. Es ist daher außerordentlich wichtig, daß die isolierende Schicht eine gleichmäßige Struktur mit einer geringen Anzahl von sogenannten "pin holes" aufweist.

Zum Übertragen der Ladungen in das Floating-Gate sind eine Vielzahl von Verfahren bekannt, wie z. B. Injektion heißer Ladungsträger, Kanalinjektion und Fowler-Nordheim-Tunneln. Bei allen diesen Verfahren ist die anzulegende Steuerspannung an das Steuer-Gate zum Einschreiben, Auslesen und Löschen der Ladungen in aus dem Floating-Gate eine Funktion der Kapazität zwischen dem Floating-Gate und dem Steuer-Gate und folglich abhängig von der Dicke der entspechenden isolierenden Schicht. Zur Verringerung der für das Programmieren bzw. Einbringen von Ladungen in das Floating-Gate notwendingen Steuerspannung wurde beispielsweise vorgeschlagen, die Dicke der isolierenden Schicht zu verringern.

Wenn jedoch die Dicke der dielektrischen Schicht verringert ist, verschlechtert sich das Speichervermögen des Floating-Gates aufgrund von Leckströmen über die sogenannten "pin holes" und andere Defekte in der isolierenden Schicht.

Herkömmliche Halbleiter-Speicherzellen und zugehörige Verfahren zu deren Herstellung verwenden daher als isolierende Schicht zwischen dem Floating-Gate und dem Steuer-Gate eine Oxid/Nitrid/Oxid (ONO)-Schicht. Diese besitzt den Vorteil, daß ein Leckstrom durch Versetzungen oder Defekte der Isolierschicht nahezu ausgeschlossen ist.

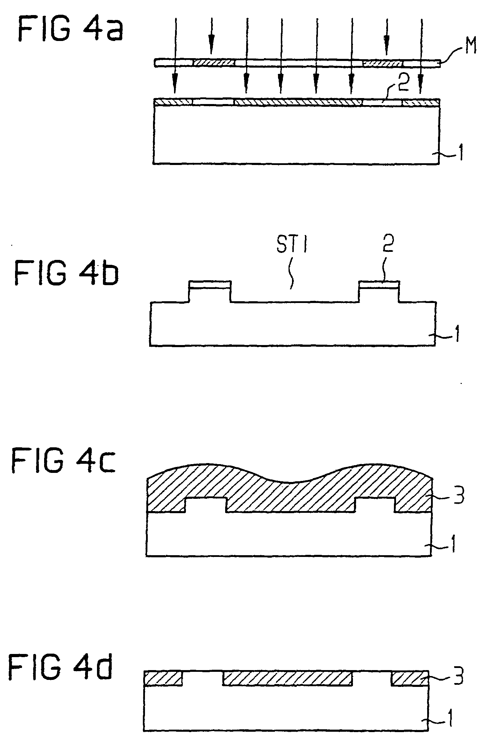

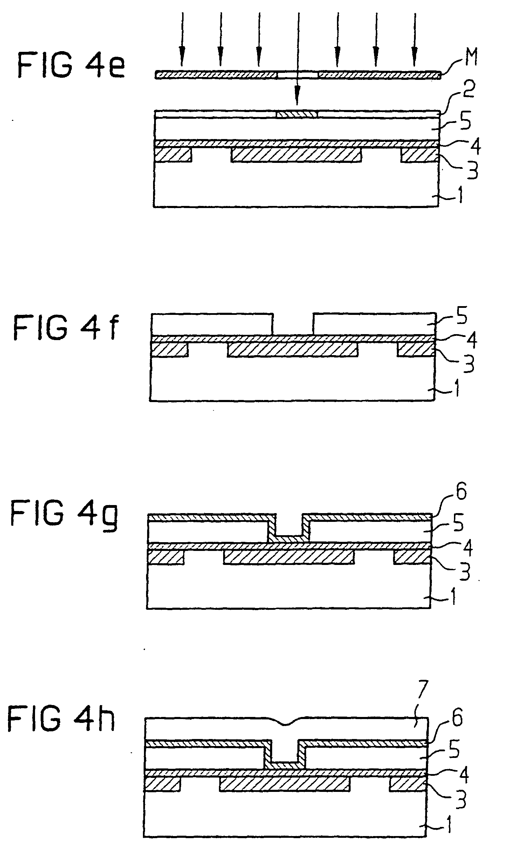

Die Figuren 4a) bis 4h) zeigen ein herkömmliches Verfahren zur Herstellung einer herkömmlichen Halbleiter-Speicherzelle auf einem Halbleitersubstrat. Gemäß Figur 4a) wird zunächst ein Halbleitersubstrat 1 mit einem Fotoresist 2 beschichtet und über eine Maske M belichtet. In einem nachfolgenden Ätzschritt (STI-Prozeß) werden gemäß Figur 4b) zwischen aktiven Gebieten flache Isoliergräben freigelegt. Nach dem Beseitigen des verbleibenden Fotoresists 2 wird das Halbleitersubstrat 1 ganzflächig mit einer $SiO_2$-Schicht als Feldoxidschicht 3 bedeckt und in einem weiteren Schritt gemäß Figur 4d) planarisiert, wodurch an den aktiven Gebieten die Oberfläche des Halbleitersubstrats 1 freigelegt wird. In einem nachfolgenden Schritt wird gemäß Figur 4e) eine Tunneloxidschicht 4, eine erste leitende Schicht 5 und ein weiterer Fotoresist 2 auf dem Halbleitersubstrat 1 sowie dem Feldoxid 3 aufgebracht und über eine weitere Maske M erneut belichtet. Im Schritt gemäß Figur 4f) wird die gemäß Figur 4e) strukturierte erste leitende Schicht 5 geätzt, wodurch Floating-Gate-Bahnen ausgebildet werden, die eine gegenüber der Kanalschicht größere Fläche aufweisen. Gemäß Figuren 4g) und 4h) wird anschließend eine zweite isolierende Schicht 6 und eine zweite leitende Schicht 7 aufgebracht, und in einem weiteren nicht dargestellten Strukturierungs- und Ätzschritt zur Ausbildung von Steuer-Gate-Bahnen ein weiterer Ätzschritt durchgeführt.

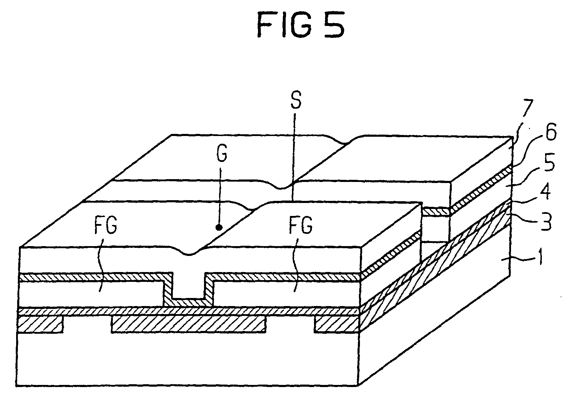

Die Figur 5 zeigt eine perspektivische Ansicht einer derart hergestellten herkömmlichen Halbleiter-Speicherzelle. Die aus der zweiten leitenden Schicht 7 hergestellten Steuer-Gate-Bahnen werden folglich durch einen Graben voneinander getrennt, in dem jeweils ein Source-Anschluß S und ein nicht dargestellter Drain-Anschluß ausgebildet werden. Der Steuer-Gate-Anschluß G befindet sich an der Oberfläche der zweiten leitenden Schicht 7. Auf diese Weise ergeben sich eine Vielzahl von matrixförmig angeordneten Halbleiter-Speicherzellen, wobei die Fläche des Floating-Gates FG ein Vielfaches der Fläche der darunterliegenden Kanalschicht aufweist, um so die für das Einbringen von Ladungen über die erste isolierende Schicht 4 notwendige kapazitive Kopplung bereit zu stellen.

Nachteilig ist bei dieser herkömmlichen Halbleiter-Speicherzelle und dem dazugehörigen Herstellungsverfahren jedoch, daß eine Vielzahl von Strukturierungsschritten mit entsprechenden Ätzschritten notwendig sind, was zum einen teuer und zum anderen zweitaufwendig ist. Ferner ist aufgrund des gegenüber der Kanalschicht vergrößerten Floating-Gates FG nur eine geringe Integrationsdichte möglich.

Zur Verbesserung der Integrationsdichte und zur Verringerung der notwendigen Steuerspannungen ist in der Druckschrift US 5,739,566 eine Halbleiter-Speicherzelle offenbart, bei der das Floating-Gate aus zwei voneinander beabstandeten Floating-Gate-Schichten besteht, die über einen Floating-Gate-Kontakt miteinander in Verbindung stehen. Auf diese Weise kann zwar die Integrationsdichte bei verringerten Steuerspannungen erhöht werden, jedoch ist dieses herkömmliche Verfahren außerordentlich aufwendig und demzufolge kostspielig.

Herstellungsverfahren einer nichtflüchtigen Halbleiterspeicherzelle sind aus US-A-4 734 887 und US-A-5 907 780 bekannt.

Der Erfindung liegt daher die Aufgabe zugrunde, eine Herstellungsverfahren einer nichtflüchtigen Halbleiter-Speicherzelle auf einem Halbleitersubstrat zu schaffen, bei dem unter Verwendung eines Standardprozesses eine weitere Verbesserung der Integrationsdichte und Verringerung der Steuerspannungen sichergestellt ist.

Diese Aufgabe wird hinsichtlich des Verfahrens durch die Maßnahmen des Patentanspruchs 1 gelöst.

Insbesondere durch die Verwendung eines selbstjustierenden Ätzschrittes, bei dem die erste leitende Schicht gemeinsam mit der ersten dielektrischen Schicht und einem Teil der Oberfläche des Halbleitersubstrats entfernt wird, in Kombination mit der Verwendung eines Materials für die zweite dielektrische Schicht, deren relative Dielektrizitätskonstante größer ist als die der ersten dielektrischen Schicht, kann eine funktionierende Halbleiter-Speicherzelle mit außerordentlich geringen Abmessungen in einem Standardprozeß hergestellt werden.

Vorzugsweise besteht eine Feldoxidschicht und die erste dielektrische Schicht aus $SiO_2$, die in Verbindung mit einem entsprechenden Ätzmittel als Ätzstoppschichten wirken, wodurch beim Ausbilden von Steuer-Gate-Bahnen gleichzeitig eine Partitionierung von Floating-Gates durchgeführt werden kannn. Auf diese Weise werden teure und zeitaufwendige Strukturierungsschritte mit der damit einhergehenden Bereitstellung von entsprechenden Masken eingespart.

Vorzugsweise besteht die zweite dielektrische Schicht aus $WO_x$ und/oder $TiO_2$, die als isolierendes Material eine hohe relative Dielektrizitätskonstante aufweisen und einen für das Schreiben/Löschen und Lesen der im Floating-Gate gespeicherten Information ausreichenden Kopplungsfaktor bereitstellen.

Die Erfindung wird nachstehend anhand eines Ausführungsbeispiels unter Bezugnahme auf die Zeichnung näher beschrieben.

Es zeigen:

Figuren 1a) bis 1f) schematische Schnittansichten zur Veranschaulichung der Verfahrensschritte zur Herstellung der Halbleiter-Speicherzelle gemäß der vorliegenden Erfindung;

Figur 2 eine perspektivische Ansicht der durch das erfindungsgemäßes Herstellungsverfahren hergestellten Halbleiter-Speicherzelle;

Figur 3 eine weitere perspektivische Ansicht der Halbleiter-Speicherzelle bei einer Schnittebene A/A' - B/B' gemäß Figur 2;

Figuren 4a) bis 4h) schematische Schnittansichten zur Veranschaulichung der Verfahrensschritte zur Herstellung einer herkömmlichen Halbleiter-Speicherzelle; und

Figur 5 eine perspektivische Ansicht einer herkömmlichen Halbleiter-Speicherzelle.

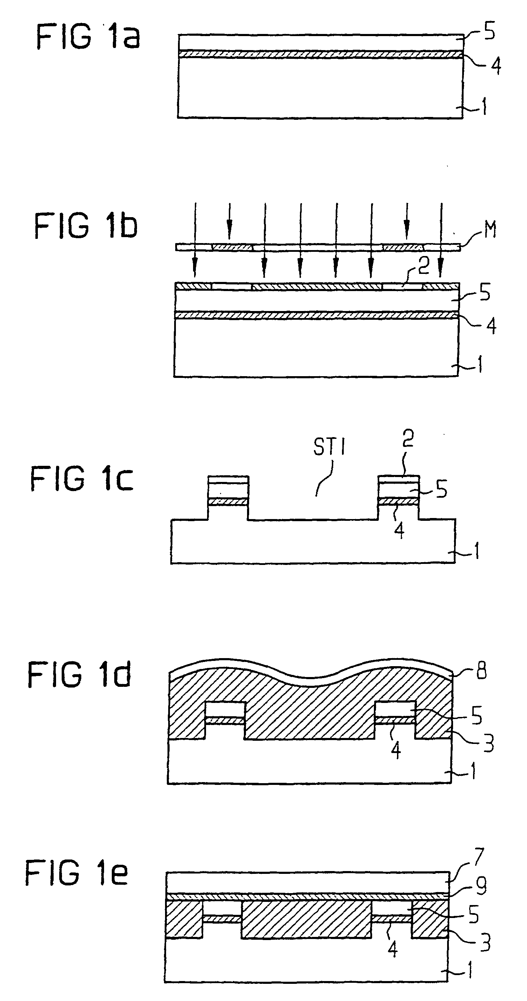

Die Figuren 1a) bis 1f) zeigen schematische Schnittansichten zur Veranschaulichung der jeweiligen Verfahrensschritte zur Herstellung einer Halbleiter-Speicherzelle gemäß einem bevorzugten Ausführungsbeispiel der Erfindung. Gemäß Figur 1a) wird zunächst ein Halbleitersubstrat 1 bereitgestellt, das vorzugsweise aus Si, SiGe, SiC, SOI, GaAs oder einem sonstigen III-V-Halbleiter besteht. In einem nachfolgenden thermischen Oxidationsprozeß wird bei einer Temperatur von ca. 900 bis 1050 °C eine erste dielektrische Schicht 4 mit geringer Dicke ausgebildet. Vorzugsweise besteht die dielektrische Schicht 4 aus thermisch erzeugtem $SiO_2$ mit einer Dicke von ca. 8 bis 13 nm. Diese erste dielektrische Schicht 4 wird auch als Tunneloxid bezeichnet, da insbesondere Tunneleffekte für das Einbringen von Ladungen durch diese erste dielektrische Schicht 4 verantwortlich sind.

Anschließend wird auf der ersten dielektrischen Schicht 4 eine dünne erste leitende Schicht 5 ausgebildet, die das spätere Floating-Gate bildet. Die erste leitende Schicht 5 besitzt eine möglichst geringe Dicke von ca. 80 nm. Vorzugsweise besteht die erste leitende Schicht 5 aus einer dotierten Polysiliziumschicht, die beispielsweise mittels eines herkömmlichen LPCVD-Abscheideverfahrens ausgebildet wird.

Auf diese Weise werden gemäß Figur 1a) bereits die Schichten für das Tunneloxid und das Floating-Gate auf besonders einfache Weise unter Verwendung von Standardprozessen bereitgestellt.

In einem Verfahrensschritt gemäß Figur 1b) wird anschließend eine erste Strukturierung mittels einer Maske M und einer auf der ersten leitenden Schicht 5 aufgebrachten fotoempfindlichen Schicht (Fotoresist) 2 durchgeführt. In diesem Schritt werden in ähnlicher Weise wie beim herkömmlichen Verfahrensschritt gemäß Figur 4b) die aktiven Gebiete der späteren Halbleiter-Speicherzelle festgelegt. Hierbei wird der Fotoresist 2 zunächst über eine Maske M belichtet, anschließend der belichtete Fotoresist 2 entwickelt und entfernt, um nachfolgend eine anisotrope Ätzung durchzuführen. Gemäß Figur 1c) wird hierfür vorzugsweise ein sogenannter STI-Prozeß (shallow trench isolation) verwendet, wobei ein Teil des Halbleitersubstrats 1 weggeätzt wird. Der Verfahrensschritt gemäß Figur 1c) entspricht somit einem selbstjustierenden Herstellungsschritt für sowohl die erste leitende Schicht 5 (Floating-Gate) als auch die darunter liegende erste dielektrische Schicht 4 und das darunter liegende nicht dargestellte Kanalgebiet. Im Gegensatz zum herkömmlichen Verfahren wurde bereits an dieser Stelle ein Strukturierungsschritt sowie die Bereitstellung einer weiteren Maske M eingespart.

Vorzugsweise wird im Verfahrensschritt gemäß Figur 1c) anisotropes reaktives Ionenätzen (RIE) angewendet, wobei das Halbleitersubstrat 1 bis zu einer Tiefe von ca. 250 nm bis 400 nm eingeätzt wird.

Im nachfolgenden Verfahrensschritt gemäß Figur 1d) wird auf der derart ausgestalteten Oberfläche ganzflächig eine Feldoxidschicht 3 abgeschieden oder (selektiv) aufgewachsen, die die aus dem Siliziumsubstrat 1, der ersten dielektrischen Schicht 4 und der ersten leitenden Schicht 5 bestehenden Schichtstapel vollständig bedeckt. Vorzugsweise besteht die Feldoxidschicht 3 aus $SiO_2$ und wird in einem TEOS-Prozeß bei einer Temperatur von ca. 450 bis 600°C abgeschieden. Nach dem Abscheiden der Feldoxidschicht 3 wird diese in einem Planarisierschritt teilweise wieder abgetragen und mit der Oberfläche der ersten leitenden Schicht 5 eingeebnet.

Zur Verbesserung dieses Planarisierschritts kann optional auf der Feldoxidschicht 3 eine weitere leitende Schicht 8 ausgebildet werden, die vorzugsweise aus Polysilizium besteht.

Anschließend wird auf der planarisierten Oberfläche des Silizium-Wafers eine zweite dielektrische Schicht 9 ganzflächig ausgebildet, die sowohl die Feldoxidschicht 3 als auch die erste leitende Schicht 5 bedeckt und eine Isolierschicht zwischen einem Floating-Gate und einem Steuer-Gate darstellt. Zur Ausbildung des Steuer-Gates wird auf der zweiten dielektrischen Schicht 9 eine zweite leitende Schicht 7 ausgebildet, die anschließend strukturiert und in Längsbahnen geätzt wird.

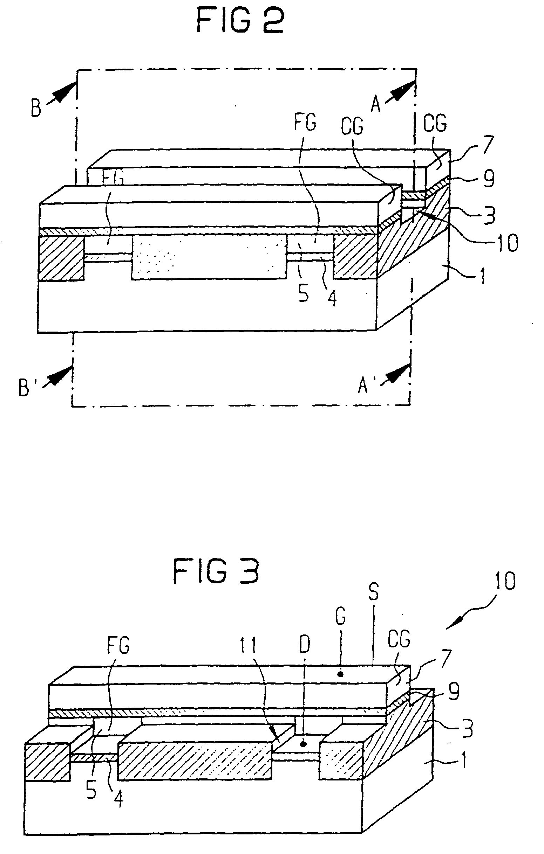

Die Figur 2 zeigt eine perspektivische Ansicht der durch das erfindungsgemäße Herstellungsverfahren hergestellten Halbleiter-Speicherzelle. Demzufolge wird die zweite leitende Schicht 7 in eine Vielzahl von Steuer-Gate-Bahnen CG geätzt, die senkrecht zu den Floating-Gate-Bahnen FG liegen und diese in einzelne Floating-Gate-Bereiche zerlegen.

Insbesondere bei Verwendung von $SiO_2$ für die erste dielektrische Schicht 4 und die Feldoxidschicht 3 wirkt das $SiO_2$ in Verbindung mit einem geeigneten Ätzmittel als Ätzstoppschicht, wodurch beim Ätzen der Steuer-Gate-Bahnen CG die einzelnen Floating-Gate-Bereiche selbstjustierend unter den Steuer-Gate-Bahnen CG ausgebildet werden.

Die Figur 3 zeigt eine perspektivische Ansicht, die diese automatisch erzeugte Struktur in einer Schnittebene A/A' - B/B' gemäß Figur 2 darstellt.

Auf diese Weise wird unter Verwendung von Standardprozessen eine Halbleiter-Speicherzelle hergestellt, die insbesondere aufgrund ihrer selbstjustierenden Verfahrensschritte für das Ausbilden eines Floating-Gates außerordentlich platzsparend sind und somit für ein hohe Integrationsdichte geeignet sind. Die Verfahrensschritte erlauben außerdem die Implementierung der Technik des Self-aligned-Contact. In diesem Fall reduziert sich der Platzbedarf pro Zelle weiter.

Wie bereits vorstehend beschrieben wurde, ist jedoch eine derartige Halbleiter-Speicherzelle bei Verwendung von herkömmlichen Materialien (z.B. ONO) für die zweite dielektrische Schicht 9 nur bei sehr hohen Steuerspannungen funktionsfähig, da der kapazitive Kopplungsfaktor zwischen dem Steuer-Gate CG und dem Floating-Gate FG nicht ausreicht, um beispielsweise über Injektion heißer Ladungsträger, Kanalinjektion oder Fowler-Nordheim-Tunneln ein Beschreiben bzw. Löschen des Floating-Gates FG mit Ladungen durchzuführen. Anstelle der herkömmlichen Oxid/Nitrid/Oxid (ONO-Schicht) verwendet die vorliegende Erfindung daher eine spezielle zweite dielektrische Schicht 9 mit einer relativen Dielektrizitätskonstante $\varepsilon_{r2}$, die größer ist als die Dielektrizitätskonstante $\varepsilon_{r1}$ der ersten dielektrischen Schicht. Genauer gesagt verwendet die vorliegende Erfindung als zweite dielektrische Schicht 9 eine Schicht mit außerordentlich hoher relativer Dielektrizitätskonstante $\varepsilon_{r2}$, wobei ferner das Auftreten der sogenannten "pin holes" vermieden ist.

Als derartige Materialen für die zweite dielektrische Schicht 9 haben sich überraschenderweise $TiO_2$ oder $WO_x$ mit

x = 2 bis 3 herausgestellt, die zum einen hervorragende Kopplungsfaktoren des Steuer-Gates CG zum Floating-Gate FG ergeben und darüber hinaus eine ausreichende Ladungshaltung im Floating-Gate FG ermöglichen.

Nachfolgend wird das Ausbilden der zweiten dielektrischen Schicht 9 für $WO_x$ und $TiO_2$ im einzelnen beschrieben.

Ausbilden einer $WO_x$-Schicht

Zum Ausbilden der zweiten dielektrischen Schicht 9 als $WO_x$ wird zunächst eine wolframhaltige Schicht, wie z. B. eine reine Wolframschicht, eine Wolframnitrid- oder eine Wolframsilizidschicht aufgebracht. Die wolframhaltige Schicht wird beispielsweise durch einen Sputter-Prozeß (PVD-Verfahren) oder durch ein CVD-Verfahren erzeugt.

Soll ein CVD-Verfahren verwendet werden, so kann auf eine Reihe von Verfahren zurückgegriffen werden:

CVD W (auf Silizium, nicht selektiv):

$$z.\ B.\ WF_6 + SiH_4 \rightarrow W + Gase\ (Keimschicht)$$

$$z.\ B.\ WF_6 + H_2 \rightarrow W + Gase\ (Bulkschicht)$$

CVD W (auf Silizium, selektiv zu Nitrid, Oxid):

$$z.\ B.\ 2WF_6\ 3\ Si \rightarrow 2\ W + 3\ (SiF_4)$$

$$z.\ B.\ WF_6 + H_2 \rightarrow W + Gase$$

CVD $WSi_x$:

$$z.\ B.\ WF_6 + SiH_2Cl_2 \rightarrow WSi_x\ (z.\ B:\ x = 2\ bis\ 3) + Gase$$

CVD WN (Wolframnitrid, z. B. $W_2N$):

$$z.\ B.\ 4WF_6 + N_2 + 12H_2\ (Plasma\ CVD) \rightarrow 4\ W_2N + 24\ (HF)$$

(z. B. bei einer Temperatur von 350 - 400° C)

Die Schichtdicke der so erzeugten wolframhaltigen Schicht beträgt ca. 10 bis 20 nm. Anschließend wird die wolframhaltige Schicht durch eine thermische Oxidation in eine Wolframoxidschicht umgewandelt, die der zweiten dielektrischen Schicht 9 entspricht. Die Umwandlung findet in einer Sauerstoffatmosphäre (beispielsweise $O_2$ oder $H_2O$) bei einer Temperatur von 500 bis 1200 °C statt. Bei der Verwendung einer reinen Wolframschicht oder einer Wolframsilizidschicht sollte die Temperatur etwa 600 °C nicht übersteigen oder eine sogenannte "low thermal budget" RTO ("rapid thermal oxidation") durchgeführt werden, um zu verhindern, daß Silizium in die wolframhaltige Schicht eindiffundiert und eine Oxidation der wolframhaltigen Schicht verhindert wird.

Die thermische Oxidation der wolframhaltigen Schicht führt zu einer zweiten dielektrischen Schicht (Wolframoxidschicht) 9, die kaum Verunreinigungen und eine relative Dielektrizitätskonstante $\varepsilon_r$ von größer als 50 aufweist. Die Schichten und Prozeßparameter werden hierbei vorzugsweise so gewählt,daß die wolframhaltige Schicht vollständig in die Wolframoxidschicht bzw. in die zweite dielektrische Schicht 9 umgewandelt wird. Anschließend wird, wie bereits vorstehend beschrieben wurde, die zweite leitende Schicht 7 auf der Wolframoxidschicht bzw. zweiten dielektrischen Schicht 9 ausgebildet. In ähnlicher Weise wie bei der ersten leitenden Schicht 5 kann auch die zweite leitende Schicht aus Polysilizium bestehen.

Bei der Verwendung von Silizium für die erste leitende Schicht 5 kann auch direkt eine Wolframoxidschicht als zweite dielektrische Schicht 9 aufgebracht werden. Diese Wolframoxidschicht kann beispielsweise durch ein CVD-Verfahren erzeugt werden. Dazu werden Wolframfluorid und Wasser im gasförmigen Zustand als Precusoren auf die planarisierte Oberfläche geführt:

$$2WF_6 + 4\,H_2O \rightarrow (WOF_4) + WO_3 + (HF)$$

oder

$$WF_6 + H_2O + Si \rightarrow W\text{-}O + (2\,HF) + (SiF_4).$$

Dies führt zur Abscheidung einer etwa 2 bis 20 nm dicken Wolframoxidschicht als zweite dielektrische Schicht 9.

Durch eine nachfolgende Wärmebehandlung bei einer Temperatur von etwa 550 bis 1100 °C in einer inerten Atmosphäre läßt sich die Wolframoxidschicht in einer kristallinen oder gesinterten Phase (beispielsweise Phasen mit einer orthorhombischen oder tetragonalen Symmetrie) erzeugen. Diese Wärmebehandlung kann bereits direkt im Anschluß an die Erzeugung der Wolframoxidschicht erfolgen oder erst in einem späteren Prozeßschritt, nachdem bereits die zweite leitende Schicht 7 für das Steuer-Gate CG aufgebracht wurde.

Ausbilden einer Titandioxidschicht

An Stelle der vorstehend beschriebenen Wolframoxidschicht kann für die zweite dielektrische Schicht 9 vorzugsweise auch eine Titandioxidschicht verwendet werden. Hierbei wird zunächst eine Titanschicht beispielsweise durch einen Sputter-Prozeß an der Oberfläche abgeschieden, wobei die Schichtdicke ca. 6 - 50 nm beträgt. Vorzugsweise beträgt die Dicke dieser Titanschicht 20nm, wodurch einerseits die Festigkeit gegenüber Leckströmen und andererseits ein Sauerstoff-Plasmaätzen bei 200 - 300 °C verwendet werden kann.

Anschließend wir die Titanschicht durch eine thermische Oxidation in eine Titandioxidschicht als zweite dielektrische Schicht 9 umgewandelt. Die Umwandlung findet in einer Sauerstoffatmosphäre bei etwa 600 °C statt. Die thermische Oxidation der Titanschicht führt zu einer sehr reinen und stökiometrischen Titandioxidschicht, die kaum Verunreinigungen aufweist. Außerdem werden bei der thermischen Oxidation Sauerstoffatome aus der Oberfläche in die Metallschicht gezogen, so daß eine eventuell entstehende Siliziumdioxidschicht an der Oberfläche der zweiten leitenden Schicht 5 bei der thermischen Oxidation der Titandioxidschicht 9 vollständig entfernt wird. Auf diese Weise entsteht eine sehr saubere Grenzfläche zwischen der ersten leitenden Schicht 5 für das Floating-Gate und der Titandioxidschicht als zweite dielektrische Schicht 9. Dies wirkt sich insbesondere positiv für die Vermeidung der eingangs beschriebenen Leckströme aus, wodurch die in das Floating-Gate FG eingebrachten Ladungen besonders gut gehalten werden können.

Durch eine nachfolgende Temperung bei ca. 900 °C läßt sich eine Titandioxidschicht in der sogenannten Rutile-Phase erzeugen. Diese Temperung kann bereits bei der Erzeugung der Titandioxidschicht erfolgen. Sie kann aber auch erst in einem spätern Prozeßschritt nach Ausbilden der zweiten leitenden Schicht 7 durchgeführt werden.

Die relative Dielektrizitätskonstante $\varepsilon_{r2}$ der auf diese Weise hergestellten Titandioxidschicht ($TiO_2$) besitzt demzufolge einen wesentlich höheren Wert als die relative Dielektrizitätskonstante $\varepsilon_{r1}$ der ersten dielektrischen Schicht, wodurch sich ein kapazitiver Kopplungsfaktor für das Steuer-Gate zum Floating-Gate ergibt, der ausreichend groß ist, um über die kleine Fläche ein Schreiben, Lesen und Löschen von Informationen in die Speicherzelle bei Anlegen von kleinen Steuerspannungen durchzuführen.

**Patentansprüche**

**1.** Verfahren zur Herstellung einer nichtflüchtigen Halbleiter-Speicherzelle auf einem Halbleitersubstrat mit den Schritten:

a) Ausbilden einer ersten dielektrischen Schicht (4) mit einer ersten relativen Dielektrizitätskonstante $\varepsilon_{r1}$ auf dem Halbleitersubstrat (1);
b) Ausbilden einer ersten leitenden Schicht (5) auf der ersten dielektrischen Schicht (4);
c) selbstjustierendes Ätzen der ersten leitenden Schicht (5), der ersten dielektrischen Schicht (4) und eines Teils der Oberfläche des Halbleitersubstrats (1) zum Ausbilden einer strukturierten Oberfläche mit Floating-Gate-Bahnen (FG);
d) Ausbilden einer Feldoxidschicht (3) auf der strukturierten Oberfläche;
e) Planarisieren der Feldoxidschicht (3) und Freilegen der ersten leitenden Schicht (5);
f) Ausbilden einer zweiten dielektrischen Schicht (9) auf der planarisierten Feldoxidschicht (3) und der ersten leitenden Schicht (5);

g) Ausbilden einer zweiten leitenden Schicht (7) auf der zweiten dielektrischen Schicht (9); und

h) Ätzen der zweiten leitenden Schicht (7), der zweiten dielektrischen Schicht (9) und der ersten leitenden Schicht (5) zum Ausbilden einer strukturierten Oberfläche mit Steuer-Gate-Bahnen (CG) und Floating-Gate-Bereichen (FG),

**dadurch gekennzeichnet, daß** in Schritt

f) eine metallhaltige Schicht ausgebildet und mittels thermischer Oxidation in eine Metalloxidschicht umgewandelt wird, wobei die zweite dielektrische Schicht (9) eine zweite relative Dielektrizitätskonstante $\varepsilon_{r2}$ aufweist, die größer als die erste relative Dielektrizitätskonstante $\varepsilon_{r1}$ ist.

**2.** Verfahren nach Patentanspruch 1,

**dadurch gekennzeichnet, daß** die Feldoxidschicht (3) und die erste dielektrische Schicht (4) aus $SiO_2$ bestehen und als Ätzstoppschichten wirken.

**3.** Verfahren nach Patentanspruch 1 oder 2,

**dadurch gekennzeichnet, daß** die zweite dielektrische Schicht (9) aus $TiO_2$ und/oder $WO_x$, mit x = 2 bis 3, bestehen.

**4.** Verfahren nach einem der Patentansprüche 1 bis 3,

**dadurch gekennzeichnet, daß** das Abscheiden der Feldoxidschicht (3) in Schritt d) einen TEOS-Prozeß darstellt.

## Claims

**1.** Method for fabricating a nonvolatile semiconductor memory cell on a semiconductor substrate, comprising the following steps:

a) forming a first dielectric layer (4) which has a first relative dielectric constant $\varepsilon_{r1}$ on the semiconductor substrate (1);

b) forming a first conductive layer (5) on the first dielectric layer (4);

c) self-aligning etching of the first conductive layer (5), of the first dielectric layer (4) and of part of the surface of the semiconductor substrate (1), in order to form a patterned surface with floating-gate tracks (FG);

d) forming a field oxide layer (3) on the patterned surface;

e) planarizing the field oxide layer (3) and uncovering the first conductive layer (5);

f) forming a second dielectric layer (9) on the planarized field oxide layer (3) and the first conductive layer (5);

g) forming a second conductive layer (7) on the second dielectric layer (9); and

h) etching the second conductive layer (7), the second dielectric layer (9) and the first conductive layer (5) in order to form a patterned surface with control-gate tracks (CG) and floating-gate regions (FG),

**characterized in that** in step

f) a metal-containing layer is formed and is converted into a metal oxide layer by means of thermal oxidation, the second dielectric layer (9) having a second relative dielectric constant $\varepsilon_{r2}$ which is greater than the first relative dielectric constant $\varepsilon_{r1}$.

**2.** Method according to Patent Claim 1, **characterized in that** the field oxide layer (3) and the first dielectric layer (4) consist of $SiO_2$ and act as etching stop layers.

**3.** Method according to Patent Claim 1 or 2, **characterized in that** the second dielectric layer (9) consists of $TiO_2$ and/or $WO_x$, where x = 2 to 3.

**4.** Method according to one of Patent Claims 1 to 3, **characterized in that** the deposition of the field oxide layer (3) in step d) represents a TEOS process.

## Revendications

**1.** Procédé de production d'une cellule de mémoire à semi-conducteur non volatile sur un substrat semi-conducteur comprenant les stades :

a) de constitution d'une première couche (4) diélectrique ayant une première constante $\varepsilon_{r1}$ diélectrique relative

sur le substrat (1) semi-conducteur ;

b) de constitution d'une première couche (5) conductrice sur la première couche (4) diélectrique ;

c) d'attaque avec autoalignement de la première couche (5) conductrice, de la première couche (4) diélectrique et d'une partie de la surface du substrat (1) semi-conducteur pour constituer une surface structurée ayant des pistes (FG) de grille flottante ;

d) de constitution d'une couche (3) d'oxyde de champ sur la surface structurée ;

e) de planarisation de la couche (3) d'oxyde de champ et de mise à nu de la première couche (5) conductrice ;

f) de constitution d'une deuxième couche (9) diélectrique sur la couche (3) d'oxyde de champ planarisée et sur la première couche (5) conductrice ;

g) de constitution d'une deuxième couche (7) conductrice sur la deuxième couche (9) diélectrique ; et

h) d'attaque de la deuxième couche (7) conductrice, de la deuxième couche (9) diélectrique et de la première couche (5) conductrice pour constituer une surface structurée ayant des pistes (CG) de grille de commande et des zones (FG) de grille flottante,

**caractérisé en ce qu'**au stade f) on constitue une couche contenant du métal et on la transforme, au moyen d'une oxydation thermique, en une couche d'oxyde métallique, la deuxième couche (9) diélectrique ayant une deuxième constante $\varepsilon_{r2}$ diélectrique relative qui est plus grande que la première constante $\varepsilon_{r1}$ diélectrique relative.

2. Procédé suivant la revendication 1,
   **caractérisé en ce que** la couche (3) d'oxyde de champ et la première couche (4) diélectrique sont en $SiO_2$ et agissent en tant que couches d'arrêt d'attaque.

3. Procédé suivant la revendication 1 ou 2,
   **caractérisé en ce que** la deuxième couche (9) diélectrique est en $TiO_2$ et/ou en $WO_x$, avec x = 2 à 3.

4. Procédé suivant l'une des revendications 1 à 3,
   **caractérisé en ce que** le dépôt de la couche (3) d'oxyde de champ au stade d) constitue un processus TEOS.

FIG 1a

FIG 1b

FIG 1c

FIG 1d

FIG 1e

# FIG 2

B

A

FG  CG  CG

B  FG

7

9

3

10

5  4

1

B'  A'

# FIG 3

S  10

FG  11  D  G  CG

7

9

3

5  4  1

FIG 4a

M

2

1

FIG 4b

ST 1

2

1

FIG 4c

3

1

FIG 4d

3

1

FIG 4e

FIG 4f

FIG 4g

FIG 4h

# FIG 5